# EUROPEAN PATENT APPLICATION

(11) **EP 3 062 358 A1**
(43) Date of publication of application: **31.08.2016**
(21) Application number: 14856266.3
(22) Date of filing: 21.10.2014
(51) Int. Cl.: H01L 35/32, H02N 11/00

(54) **THERMOELECTRIC CONVERSION DEVICE HAVING THERMOELECTRIC CONVERSION ELEMENT CONNECTED THERETO VIA WIRING PATTERN, AND METHOD FOR MANUFACTURING THERMOELECTRIC CONVERSION DEVICE HAVING THERMOELECTRIC CONVERSION ELEMENT CONNECTED THERETO VIA WIRING PATTERN**

(30) Priority: 25.10.2013 JP 2013222259
(71) Applicant: DENSO CORPORATION, Kariya-city, Aichi 448-8661 (JP)
(72) Inventor: GOUKO, Norio, Kariya-city Aichi 448-8661 (JP); SAKAIDA, ATUSI, Kariya-city Aichi 448-8661 (JP); TANIGUCHI, Toshihisa, Kariya-city Aichi 448-8661 (JP); SHIRAISHI, Yoshihiko, Kariya-city Aichi 448-8661 (JP); OKAMOTO, Keiji, Kariya-city Aichi 448-8661 (JP)
(74) Representative: Kuhnen & Wacker
(86) International application number: PCT/JP2014/077949
(87) International publication number: WO 2015/060301

(57) **Abstract**

A converter includes a first insulating substrate (10) having a first surface (10a) on which a wiring pattern (11) is formed, a second insulating substrate (20) integrated with the first insulating substrate, and a plurality of thermoelectric conversion elements (30) of the same conductivity type arranged between the first and second insulating substrates and connected in series via the wiring pattern. The wiring pattern includes a plurality of first connecting portions (11a) formed in a first region of the first insulating substrate, a plurality of second connecting portions (11b) formed in a second region thereof, and a plurality of coupling portions (11c) coupling the first connecting portions to the second connecting portions, to connect a set of first and second connecting portions to thermoelectric conversion elements. The coupling portions each couple, in adjacent thermoelectric conversion elements, a first connecting portion connected to one of the thermoelectric conversion elements to a second connecting portion connected to the other of the thermoelectric conversion elements.

## Description

### [Technical Field]

The present disclosure relates to a thermoelectric conversion technique, and in particular relates to a thermoelectric converter in which thermoelectric conversion elements are connected to a wiring pattern, and a method for fabricating the thermoelectric converter.

### [Background Art]

Thermoelectric converters are widely used. As an example of such a thermoelectric converter, JP-A-2009-117792 proposes a thermoelectric converter in which N- and P-type thermoelectric conversion elements are alternately connected in series via electrodes. Specifically, in this thermoelectric converter, the N- and P-type thermoelectric conversion elements are arranged on a plurality of respective lower metal electrodes in a rectangular-plate shape. In the N- and P-type thermoelectric conversion elements arranged on adjacent lower metal electrodes, the N-type thermoelectric conversion element arranged on one lower metal electrode is electrically connected, via an upper metal electrode, to the P-type thermoelectric conversion element arranged on the other lower metal electrode. Thus, the N- and P-type thermoelectric conversion elements are alternately connected in series via the lower and upper metal electrodes.

In such a thermoelectric converter, when it is used as a Seebeck device, the upper metal electrode side is located in a high-temperature section while the lower metal electrode side is located in a low-temperature section. Further, in the P-type thermoelectric conversion elements, holes are diffused to a low-temperature side while, in the N-type thermoelectric conversion elements, electrons are diffused to the low-temperature side. Therefore, in the P-type thermoelectric conversion elements, the low-temperature side will have a high potential while, in the N-type thermoelectric conversion elements, a high-temperature side will have a high potential. Accordingly, the alternate and serial connection of the P- and N-type thermoelectric conversion elements can achieve high electromotive voltage.

### [Citation List]

### [Patent Literature]

[Patent Literature 1] JP-A-2009-117792

### [Summary of the Invention]

### [Technical Problem]

However, such a thermoelectric converter creates a problem that the structure and the fabrication steps are likely to be complicated, due to the use of two types, i.e., N- and P-types, of thermoelectric conversion elements.

In light of the matters set forth above, the present disclosure provides a thermoelectric converter capable of simplifying the structure and the fabrication steps, and a method for fabricating the thermoelectric converter.

### [Solution to Problem]

A thermoelectric converter according to a typical example of the present disclosure includes a back insulating substrate (10) having a first surface (10a) on which a wiring pattern (11) is formed, a front insulating substrate (20) arranged on the first surface of the back insulating substrate and integrated with the back insulating substrate, and a plurality of thermoelectric conversion elements (30) of the same conductivity type arranged between the back and front insulating substrates and connected in series via the wiring pattern. The thermoelectric converter has the following characteristics.

The wiring pattern includes a plurality of first connecting portions (11a) formed in a first region of the back insulating substrate, a plurality of second connecting portions (11b) formed in a second region of the back insulating substrate, the second region being different from the first region, and a plurality of coupling portions (11c) coupling the first connecting portions to the respective second connecting portions. The plurality of thermoelectric conversion elements are extended in a planar direction of the back insulating substrate and each connected to a set of first and second connecting portions. In adjacent thermoelectric conversion elements, each coupling portion is characterized by coupling the first connecting portion, connected to one of the thermoelectric conversion elements, to the second connecting portion connected to the other of the thermoelectric conversion elements.

When the thermoelectric converter configured in this way is used as a Seebeck device, for example, the first region is arranged in a high-temperature section while the second region is arranged in a low-temperature section. In this case, each coupling portion in adjacent thermoelectric conversion elements couples the first connecting portion, connected to one of the thermoelectric conversion elements, to the second connecting portion, connected to the other of the thermoelectric conversion elements. Accordingly, if the converter is configured by thermoelectric conversion elements of only one conductivity type, a large electromotive voltage can be obtained while the structure is simplified.

A typical example of a method for fabricating a thermoelectric converter of the present disclosure is characterized in that the method includes a step of forming a wiring pattern on a first surface of a back insulating substrate, a step of coating an electrically conductive paste (31) of one conductivity type onto a plurality of predetermined portions on a second surface (20a) opposed to the first surface of the back insulating substrate, a step of configuring a laminate (40) in which the back insulating substrate and the front insulating substrate are laminated such that the first surface of the back insulating substrate is opposed to the second surface of the front insulating substrate, and the electrically conductive paste coated onto each of the plurality of predetermined portions is brought into contact with a corresponding one of the first connecting portions and a corresponding one of the second connecting portions, and a step of integrating the laminate, while forming the thermoelectric conversion elements by sintering the electrically conductive paste by heating the laminate and pressing the laminate in a laminated direction.

With this configuration, an electrically conductive paste of only one conductivity type has to be coated to configure the thermoelectric conversion elements. Thus, comparing with the case of fabricating a thermoelectric converter having thermoelectric conversion elements of two types (P and N types), fabrication steps can be simplified.

It should be noted that the bracketed reference signs of individual means in this column and in the claims indicate correspondency to specific means in the embodiments described later.

### [Brief Description of the Drawings]

Fig. 1 is a cross-sectional view illustrating a thermoelectric converter according to a first embodiment of the present disclosure.
Fig. 2 is a plan view illustrating the thermoelectric converter illustrated in Fig. 1.
Fig. 3 is a plan view illustrating a back insulating substrate illustrated in Fig. 1.
Fig. 4A is a cross-sectional view illustrating a fabrication step of the thermoelectric converter illustrated in Fig. 1.
Fig. 4B is a cross-sectional view illustrating a fabrication step of the thermoelectric converter illustrated in Fig. 1.
Fig. 4C is a cross-sectional view illustrating a fabrication step of the thermoelectric converter illustrated in Fig. 1.
Fig. 4D is a cross-sectional view illustrating a fabrication step of the thermoelectric converter illustrated in Fig. 1.
Fig. 5A is a diagram illustrating a method of using the thermoelectric converter illustrated in Fig. 1.
Fig. 5B is a diagram illustrating a method of using the thermoelectric converter illustrated in Fig. 1.
Fig. 6 is a diagram illustrating a method of using the thermoelectric converter illustrated in Fig. 1.
Fig. 7A is a diagram illustrating a method of using the thermoelectric converter illustrated in Fig. 1.
Fig. 7B is a diagram illustrating a method of using the thermoelectric converter illustrated in Fig. 1.
Fig. 8 is a diagram illustrating a method of using the thermoelectric converter illustrated in Fig. 1.
Fig. 9 is a plan view illustrating a thermoelectric converter according to a second embodiment of the present disclosure.
Fig. 10 is a plan view illustrating a thermoelectric converter according to a third embodiment of the present disclosure.
Fig. 11 is a plan view illustrating a thermoelectric converter according to a fourth embodiment of the present disclosure.

### [Description of the Embodiments]

With reference to the accompanying drawings, hereinafter will be described some embodiments of the present disclosure. It should be noted that in the embodiments set forth below, those components which are identical or equivalent to each other are given the same reference signs.

### (First Embodiment)

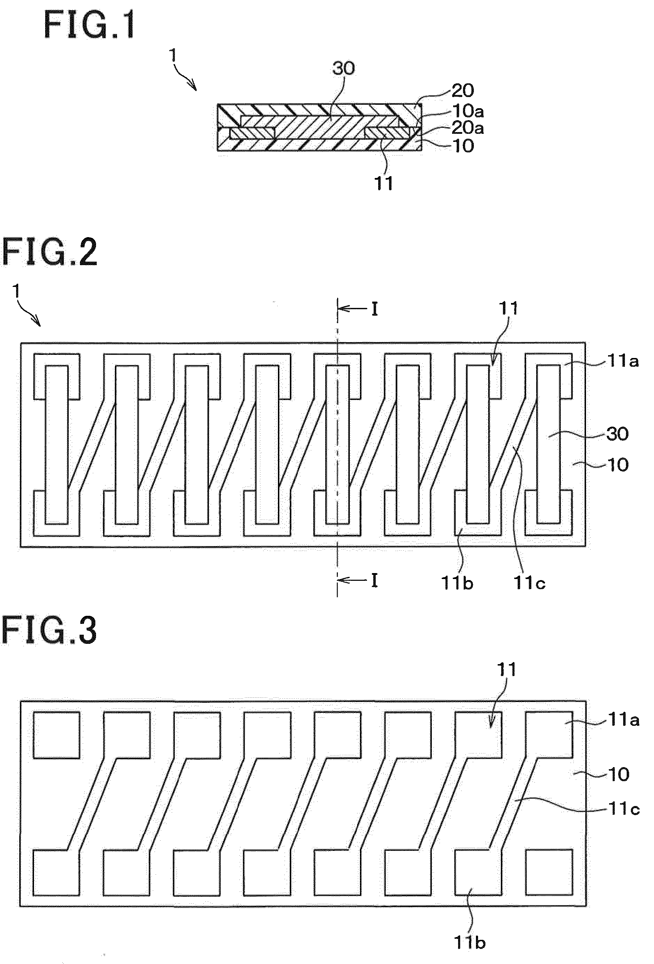

Referring to the drawings, a first embodiment of the present disclosure will be described. As shown in Figs. 1 to 3, a thermoelectric converter 1 of the present embodiment is an integration of a back insulating substrate 10 and a front insulating substrate 20. The integrated structure has an interior where a plurality of thermoelectric conversion elements 30 of one type are arranged. For the sake of clarity, the front insulating substrate 20 is omitted from Fig. 2.

The back insulating substrate 10 is formed of a thermoplastic resin film having a rectangular shape in plan view. The thermoplastic film is made of polyether ether ketone (PEEK) or polyether ketone (PEK). The back insulating substrate 10 has a surface 10a on which a wiring pattern 11 is formed.

The front insulating substrate 20 is formed of a thermoplastic resin film having a rectangular shape in plan view. The thermoplastic film is made of polyether ether ketone (PEEK) or polyether ketone (PEK). In the present embodiment, the size and shape of the front insulating substrate 20 in plan view are the same as those of the back insulating substrate 10 in plan view.

The thermoelectric conversion elements 30 are located between the back and front insulating substrate 10 and 20, and extended in a planar direction of the back insulating substrate 10 (extended parallel to the surface 10a), while being serially connected to each other via the wiring pattern 11 formed on the back insulating substrate 10. Although not particularly limited, the thermoelectric conversion elements 30 of the present embodiment are made of a metallic compound (sintered alloy) which is obtained by solid-phase sintering a Bi-Sb-Te alloy powder (metallic particles) so as to retain the crystal structure of the plurality of metallic atoms before being sintered. Specifically, the thermoelectric conversion elements 30 are P-type thermoelectric conversion elements.

The following description specifically sets forth a relationship between the configuration of the wiring pattern 11 and the thermoelectric conversion elements 30, which is characteristic of the present embodiment.

The wiring pattern 11 includes a plurality of first and second connecting portions 11a and 11b, and includes coupling portions 11c each electrically connecting a corresponding one of the first connecting portions 11a to a corresponding one of the second connecting portions 11b.

In the present embodiment, the first connecting portions 11a each have a rectangular shape in plan view. The back insulating substrate 10 has a first end (upper end portion as viewed in Fig. 2 or 3) region in the direction along the short side thereof, the direction being perpendicular to the longitudinal direction of the substrate 10, while being parallel to the planar direction of the substrate 10. In the first end region, the first connecting portions 11a are formed at regular intervals along the longitudinal direction of the back insulating substrate 10.

The second connecting portions 11b, each having a rectangular shape in plan view similar to the first connecting portions 11a, are formed by the same number as that of the first connecting portions 11a. The back insulating substrate 10 has a second end (lower end portion as viewed in Fig. 2 or 3) region which is in a direction along the short side of the back insulating substrate 10. In the second end region, the second connecting portions 11b are formed at regular intervals along the longitudinal direction of the back insulating substrate 10.

In the present embodiment, the first end region along the short side corresponds to the first region of the present disclosure while the second end region along the short side corresponds to the second region of the present disclosure. The interval between the first connecting portions 11a is ensured to be equal to the interval between the second connecting portions 11b. Further, the first connecting portions 11a are formed so as to face the respective second connecting portions 11b, in the direction along the short side of the back insulating substrate 10. In other words, a plurality of pairs of first and second connecting portions 11a and 11b are arranged in the longitudinal direction of the back insulating substrate 10, and in each of the pairs, the first connecting portion 11a is opposed to the second connecting portion 11b.

It should be noted that the back insulating substrate 10 corresponds to the first insulating substrate while the front insulating substrate 20 corresponds to the second insulating substrate.

Each of the plurality of thermoelectric conversion elements 30 is in a rod shape extended in a direction parallel to the short side of the back insulating substrate 10. Each of the thermoelectric conversion elements 30 has an end connected to the first connecting portion 11a of a corresponding one of the pairs of opposed first and second connecting portions 11a and 11b, and another end connected to the second connecting portion 11b of the pair.

Each coupling portion 11c in adjacent thermoelectric conversion elements 30 is ensured to be formed so as to couple the first connecting portion 11a connected to one of the thermoelectric conversion elements 30 to the second connecting portion 11b connected to the other of the thermoelectric conversion elements 30.

Thus, a second connecting portion 11b, a thermoelectric conversion element 30, a first connecting portion 11a and a coupling portion 11c are repeatedly connected in this order to thereby connect the plurality of thermoelectric conversion elements 30 in series.

In a cross section different from the one shown in Fig. 1, the back insulating substrate 10 includes a contact portion formed being electrically connected to an external circuit. Specifically, the contact portion is formed so as to be electrically connected to the first and second contacting portions 11a and 11b (the upper left first connecting portion 11a and the lower right connecting portion 11b as viewed in Fig. 2 or 3) which are not connected to the coupling portions 11c in the wiring pattern 11.

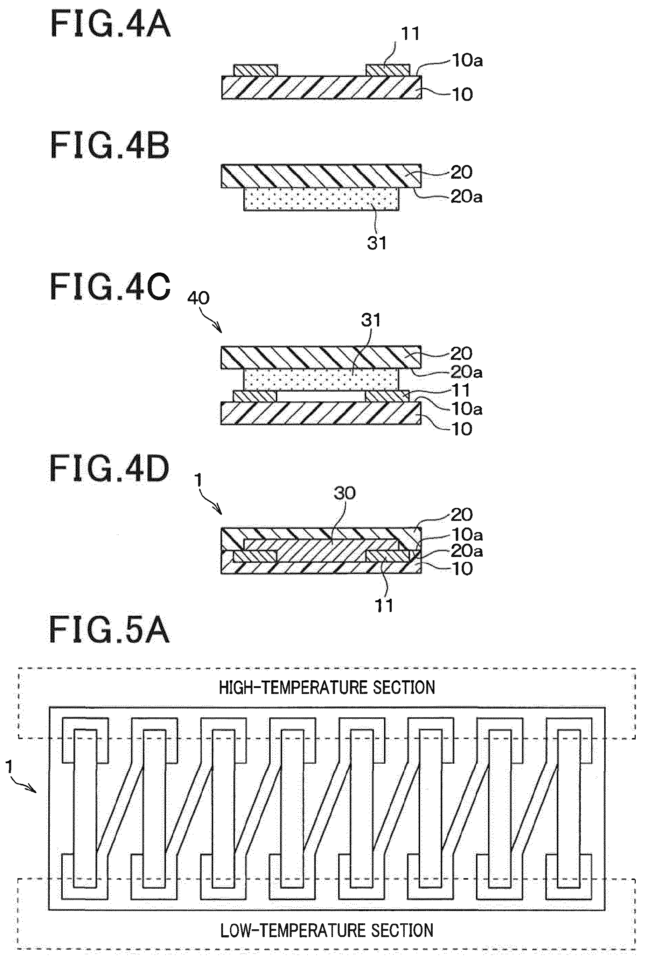

The thermoelectric converter 1 of the present embodiment is configured as described above. Referring now to Figs. 4A to 4D, a method for fabricating the thermoelectric converter 1 will be described. Figs. 4A to 4D are cross-sectional views each taken along a line I-I of Fig. 2.

As shown in Fig. 4A, the wiring pattern 11 (see Fig. 3) configured as described above is formed on the surface 10a of the back insulating substrate 10. When forming the wiring pattern 11, a metal film, such as a copper foil, is formed on the surface 10a of the back insulating substrate 10 by means, for example, of CVD (chemical vapor deposition) or the like, followed by appropriately patterning the metal film.

In a processing step separate from the one shown in Fig. 4A, an electrically conductive paste 31 is coated onto a plurality of predetermined portions of a surface 20a of the front insulating substrate 20 to serve as the thermoelectric conversion elements 30 after being sintered. For example, the electrically conductive paste 31 can be coated by printing or the like by placing a mask, which is provided with openings at predetermined positions, on the surface 20a of the front insulating substrate 20.

In the present embodiment, the electrically conductive paste 31 is obtained by adding an organic solvent, such as a terpene having a melting point at ordinary temperature, to a Bi-Sb-Te alloy powder (metallic particles). Specifically, the electrically conductive paste 31 to be used is one from which the organic solvent is evaporated while the paste 31 is being coated. In other words, the electrically conductive paste 31 to be used is one which will hardly have fluidity after being coated.

Then, as shown in Fig. 4C, the back insulating substrate 10 is laminated with the front insulating substrate 20 to configure a laminate 40. Specifically, the front insulating substrate 20 is laminated on the back insulating substrate 10 such that each pair of opposed first and second connecting portions 11a and 11b are brought into contact with a common one of the plurality of electrically conductive paste 31 portions. In other words, the front insulating substrate 20 is laminated on the back insulating substrate 10 such that one end of each of the plurality of electrically conductive paste 31 portions is in contact with the first connecting portion 11a and the other end is in contact with the second connecting portion 11b.

Then, as shown in Fig. 4D, the laminate 40 is placed between a pair of press plates, not shown. Then, the laminate 40 is pressed in the direction of lamination from above and below, while being heated in a vacuum, for integration of the laminate 40. In this case, the alloy powder is compressed and solid-phase sintered, thereby forming the thermoelectric conversion elements 30 of a metallic compound (sintered alloy) that retains the crystal structure of the plurality of metallic atoms before being sintered. The alloy powder is compressed together with the first and second connecting portions 11a and 11b, so that each of the thermoelectric conversion elements 30 is connected to the corresponding first and second connecting portions 11a and 11b. In this way, the thermoelectric converter 1 shown in Fig. 1 is fabricated.

Although not particularly limited, when integrating the laminate 40, a buffer made such as of rock wool paper may be placed between the laminate 40 and each of the press plates.

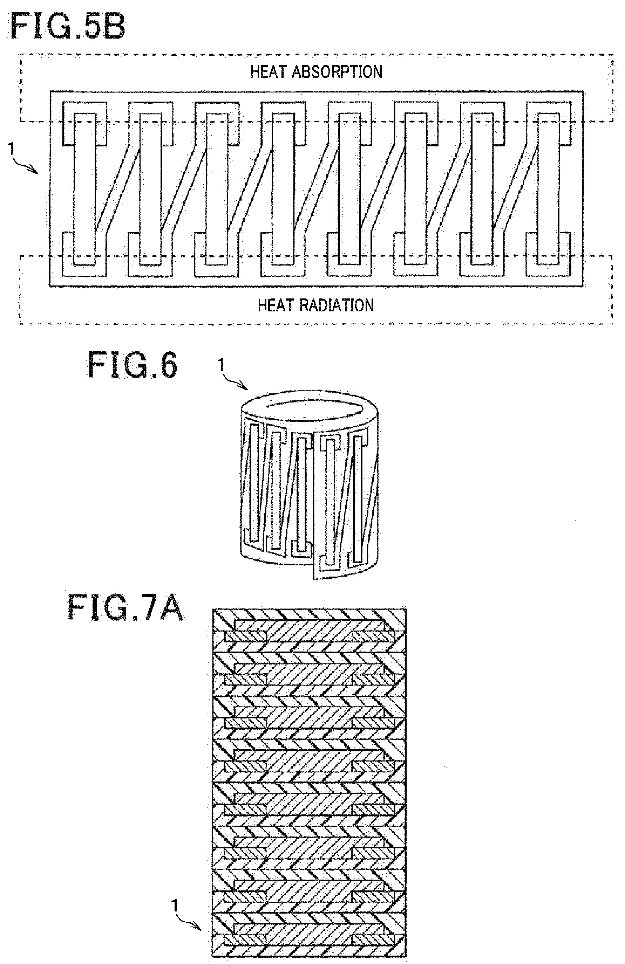

The following description sets forth a usage example of the thermoelectric converter 1. In the thermoelectric converter 1, when used as a Seebeck device, as shown in Fig. 5A, the first end (upper end portion as viewed in Fig. 5A) region in the short side direction of the back insulating substrate 10 is arranged on a high-temperature side while the second end (lower end portion as viewed in Fig. 5B) region is arranged on a low-temperature side.

On the other hand, the thermoelectric converter 1, when used as a Peltier device, as shown in Fig. 5B, has the first end (upper end portion as viewed in Fig. 5B) region in the short side direction of the back insulating substrate 10 arranged so as to be in contact with a member which is desired to be cooled. Further, the second end (lower end portion as viewed in Fig. 5B) region is used such that heat is radiated therefrom.

In this case, the shapes of the back and front insulating substrates 10 and 20 in plan view, and a printing range of the electrically conductive paste 31 configuring the thermoelectric conversion elements 30 are appropriately selected to facilitate adjustment of the spacing between the opposed first and second connecting portions 11a and 11b in each pair. Specifically, in the thermoelectric converter 1, since the thermoelectric conversion elements 30 are arranged along the planar direction of the back insulating substrate 10, the spacing between the high-temperature side (heat-absorption side) and the low-temperature side (heat-radiation side) can be easily adjusted. In this way, the degree of freedom in layout can be improved.

As shown in Fig. 6, the thermoelectric converter 1 may be rolled into a cylinder for use as a Peltier unit. In this case, for example, the cooling side of thermoelectric converter 1 is located so as to be wound about a heat-radiation side end of the heat pipe. Thus, the radiation performance (cooling performance) on the heat-radiation side is improved. In the present embodiment, the thermoelectric converter 1 is flexible because the back and front insulating substrates 10 and 20 are each made of a resin. Accordingly, the thermoelectric converter 1 can be easily deformed in conformity with the shape of an object to be mounted.

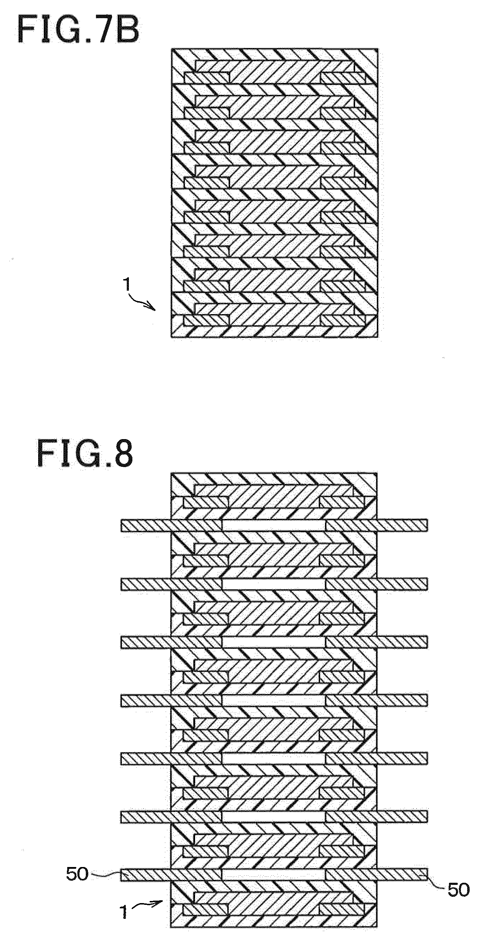

As shown in Fig. 7, a plurality of thermoelectric converters 1 may be used in a state of being stacked. In this case, as shown in Fig. 7A, the thermoelectric converters 1 shown in Fig. 1 may be just simply stacked. Alternatively, as shown in Fig. 7B, in adjacent thermoelectric converters 1 in the stacking direction (up-and-down direction as viewed in Fig. 7B), the back insulating substrate 10 of the upper thermoelectric converter 1 may be used as the front insulating substrate 20 of the lower thermoelectric converter 1.

As a modification of the stack shown in Fig. 7A, metals (fins) 50, such as Al or Cu, having high heat conductivity may each be arranged, as shown in Fig. 8, between the thermoelectric converters 1. With this configuration, heat can be further efficiently absorbed and radiated.

As described above, according to the present embodiment, the first connecting portions 11a are formed on the first end region in the short side direction of the back insulating substrate 10 while the second connecting portions 11b are formed on the second end region. Further, each of the thermoelectric conversion elements 30 has an end connected to a corresponding one of the first connecting portions 11a, and has the other end connected to a corresponding one of the second connecting portions 11b.

Thus, when the thermoelectric converter 1 is arranged as shown in Fig. 5A, for example, holes diffuse to the low-temperature side of the thermoelectric conversion elements 30. In this regard, in adjacent thermoelectric conversion elements 30, the coupling portion 11c is formed so as to connect the first connecting portion 11a, connected to one of the thermoelectric conversion elements 30, to the second connecting portion 11b, connected to the other of the thermoelectric conversion elements 30. Accordingly, use of only the thermoelectric conversion elements 30 of the same conductivity type can achieve a large electromotive voltage while the structure is simplified.

Being configured in this way, the thermoelectric converter 1 can be fabricated by coating only one type of electrically conductive paste 31 onto the front insulating substrate 20. Therefore, compared to the method for fabricating a thermoelectric converter including two types of thermoelectric conversion elements, fabrication steps can be simplified.

In the present embodiment, P-type elements are used as the thermoelectric conversion elements 30. Thus, there is no need of using highly toxic selenium which is often used in configuring N-type thermoelectric conversion elements. Accordingly, safety can be easily managed in the fabrication steps.

The thermoelectric conversion elements 30 are arranged in the planar direction of the back insulating substrate 10. Thus, for example, by appropriately changing the shape of the back insulating substrate 10 in plan view, or the printing range of the electrically conductive paste 31 configuring the thermoelectric conversion elements 30, the spacing between the first and second connecting portions 11a and 11b can be easily changed. In other words, the spacing between the first and second connecting portions 11a and 11b can be easily changed according to usages and thus the degree of freedom in design can be enhanced.

For example, as shown in Fig. 5A, in a usage, the first end region in the short side direction of the back insulating substrate 10 can be arranged on the high-temperature side while the second end region can be arranged on the low-temperature side. In this usage, the spacing between the high- and low-temperature side regions can be easily changed. Accordingly, the spacing between the high- and low-temperature side regions can be easily increased. In this case, the temperature difference between the high- and low-temperature side regions can be easily retained, thereby obtaining a large voltage.

As shown in Fig. 5B, the first end region in the short side direction of the back insulating substrate 10 can be used for cooling, and the second end region can be used for heat radiation. In this usage, thermal migration occurs in the planar direction of the back insulating substrate 10. Thus, the spacing between the cooling-side region and the radiation-side region can be easily increased, thereby enhancing the degree of freedom in layout.

The back and front insulating substrates 10 and 20 are each made of a resin. Thus, the thermoelectric converter 1 can be easily deformed in conformity with an object to be mounted.

### (Second Embodiment)

The following description sets forth a second embodiment of the present disclosure. The present embodiment is different from the first embodiment in that the wiring pattern 11 has been changed. Since the rest of the configuration is similar to the first embodiment, description is omitted.

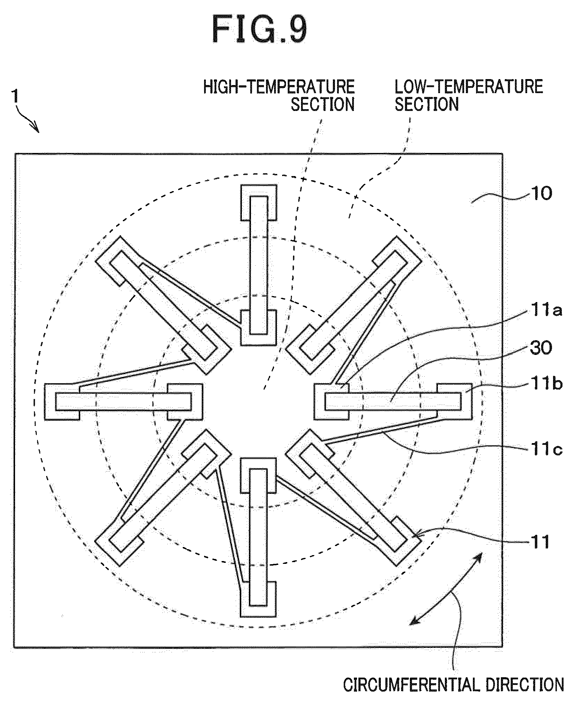

In the present embodiment, as shown in Fig. 9, the first and second connecting portions 11a and 11b are formed so as to be concentrically arranged at regular intervals in a circumferential direction, centering on a predetermined reference point on the surface 10a of the back insulating substrate 10. In the present embodiment, the first connecting portions 11a are formed on an inner-circular region while the second connecting portions 11b are formed on an outer-circular region in a circular region centering on the predetermined reference point.

In the present embodiment, the predetermined reference point coincides with the center of the surface 10a of the back insulating substrate 10. The inner-circular region corresponds to the first region of the present disclosure and the outer-circular region corresponds to the second region of the present disclosure. For the sake of clarity, the front insulating substrate 20 is omitted from Fig. 9.

The plurality of thermoelectric conversion elements 30 are radially arranged relative to the predetermined reference point.

The thermoelectric converter 1 configured in this way can also obtain advantageous effects similar to those of the first embodiment. When the thermoelectric converter 1 of the present embodiment is used as a Seebeck device, for example, the inner-circular side of the thermoelectric converter 1 (back insulating substrate 10) is preferably used as a high-temperature section while the outer-circular side thereof is used as a low-temperature section. The thermoelectric converter 1 of the present embodiment is fabricated by appropriately changing the printing range of the wiring pattern 11 and the electrically conductive paste 31. Therefore, fabrication steps will not be particularly increased compared to the first embodiment.

### (Third Embodiment)

The following description sets forth a third embodiment of the present disclosure. The present embodiment is different from the first embodiment in that the wiring pattern 11 has been changed. Since the rest of the configuration is similar to the first embodiment, description is omitted.

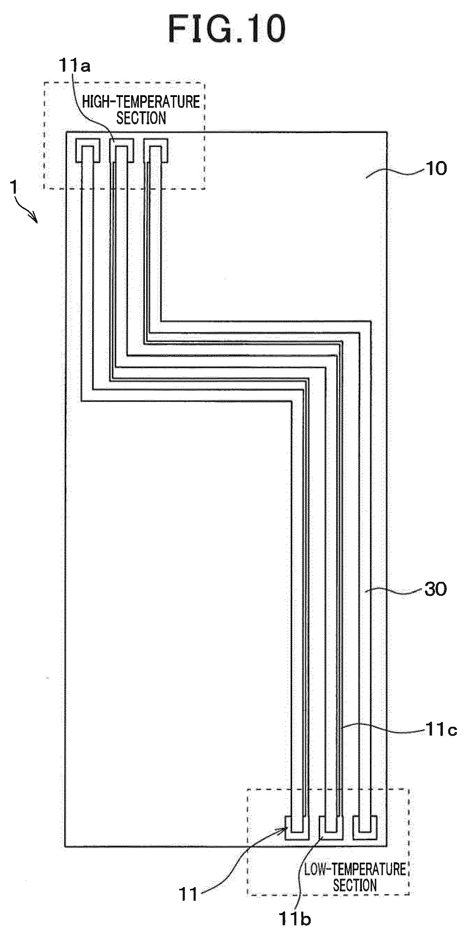

In the present embodiment, as shown in fig. 10, the plurality of first connecting portions 11a are formed in a first end (upper end portion as viewed in Fig. 10) region in the longitudinal direction of the back insulating substrate 10. Specifically, in the first end region, the first connecting portions 11a are formed in a first lateral end (left end portion as viewed in Fig. 10) region which is in the short side direction.

In contrast, the plurality of second connecting portions 11b are formed in a second end (lower end portion as viewed in Fig. 10) region in the longitudinal direction of the back insulating substrate 10. Specifically, in the second end region, the second connecting portions 11b are formed in a second lateral end (right end portion as viewed in Fig. 10) region which is in the short side direction.

In the present embodiment, in the first end region in the longitudinal direction of the back insulating substrate 10, the first lateral end region along the short side corresponds to the first region. Also, in the second end region in the longitudinal direction of the back insulating substrate 10, the second lateral end region along the short side corresponds to the second region. For the sake of clarity, the front insulating substrate 20 is omitted from Fig. 10.

The thermoelectric elements 30 are each in a polyline shape so as to connect the first connecting portions 11a to the respective second connecting portions 11b. Similarly, the coupling portions 11c are in a polyline shape along the respective thermoelectric conversion elements 30.

The thermoelectric converter 1 configured in this way can obtain advantageous effects similar to those of the first embodiment. When the thermoelectric converter 1 of the present embodiment is used as a Seebeck device, for example, it is preferable that the first lateral end region in the short side direction in the first end region, which is in the longitudinal direction of the thermoelectric converter 1 (back insulating substrate 10), serves as a high-temperature section, and that the second lateral end region in the short side direction in the second end region, which is in the longitudinal direction, serves as a low-temperature section. The thermoelectric converter 1 of the present embodiment is fabricated by appropriately changing the printing range of the wiring pattern 11 and the electrically conductive paste 31. Therefore, fabrication steps will not be increased compared to the first embodiment.

### (Fourth Embodiment)

The following description sets forth a fourth embodiment of the present disclosure. The present embodiment is different from the third embodiment in that the wiring pattern 11 has been changed. Since the rest of the configuration is similar to the third embodiment, description is omitted.

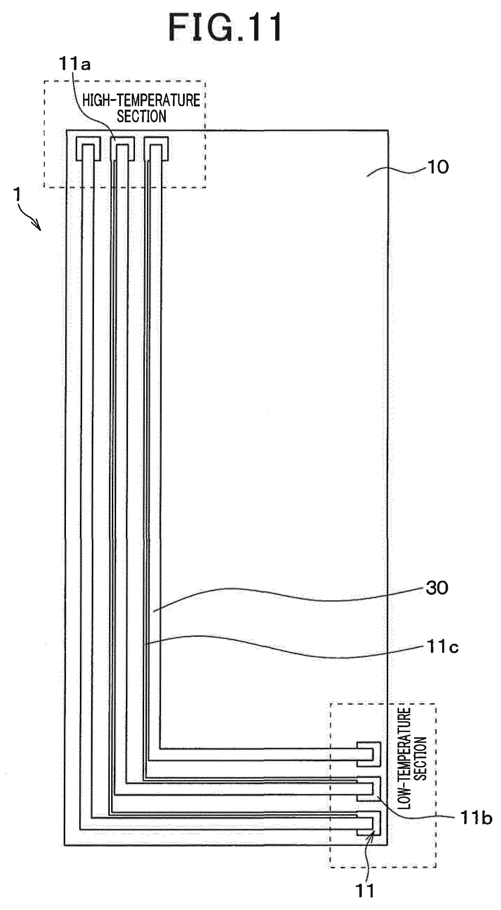

In the present embodiment, as shown in Fig. 11, the plurality of second connecting portions 11b are formed in the second end (lower end portion as viewed in Fig. 11) region in the longitudinal direction of the back insulating substrate 10. Specifically, in the second end region, the second connecting portions 11b are formed along the longitudinal direction in a second lateral end (right end portion as viewed in Fig. 11) region which is in the short side direction. For the sake of clarity, the front insulating substrate 20 is omitted from Fig. 11.

The thermoelectric conversion elements 30 are each in an L shape so as to connect the first connecting portions 11a to the respective second connecting portions 11b. Similarly, the coupling portions 11c are in an L shape extended along the respective thermoelectric conversion elements 30.

The thermoelectric converter 1 configured in this way can obtain advantageous effects similar to those of the third embodiment. The thermoelectric converter 1 of the present embodiment is fabricated by appropriately changing the printing range of the wiring pattern 11 and the electrically conductive paste 31. Therefore, fabrication steps will not be increased compared to the third embodiment.

### (Other Embodiments)

The present invention should not be construed as being limited to the foregoing embodiments, but can be appropriately changed within a scope of the claims.

For example, in the foregoing embodiments, the thermoelectric conversion elements 30 may be N-type elements made of a metallic compound (sintered alloy) which is obtained by solid-phase sintering a Bi-Te alloy powder (metallic particles) so as to retain the crystal structure of the plurality of metallic atoms before being sintered. The alloy powder composing the thermoelectric conversion elements 30 may be appropriately selected from materials obtained by alloying copper, constantan, chromel, alumel and the like, with iron, nickel, chrome, copper, silicon and the like. Alternatively, the alloy powder may be appropriately selected from alloys of tellurium, bismuth, antimony, or selenium, or alloys of silicon, iron, aluminum, or the like.

In the foregoing embodiments, the organic solvent contained in the electrically conductive paste 31 may be, for example, a paraffin or the like having a melting point of 43°C. When using such an organic solvent, the organic solvent is preferably evaporated after the step shown in Fig. 4B, for example, to minimize wet expansion of the electrically conductive paste 31.

### [Reference Signs List]

- 1: Thermoelectric converter
- 10: Back insulating substrate
- 10a: Surface
- 11: Wiring pattern
- 11a: First connecting portion
- 11b: Second connecting portion
- 11c: Coupling portion
- 20: Front insulating substrate
- 20a: Surface
- 30: Thermoelectric conversion element

## Claims

1. A thermoelectric converter, **characterized in that** the converter comprises:
a first insulating substrate (10) having a first surface (10a) on which a wiring pattern (11) is formed;
a second insulating substrate (20) arranged on the first surface of the first insulating substrate and integrated with the first insulating substrate; and
a plurality of thermoelectric conversion elements (30) of the same conductivity type arranged between the first insulating substrate and the second insulating substrate and connected in series via the wiring pattern, wherein:
the wiring pattern includes a plurality of first connecting portions (11a) formed in a first region of the first insulating substrate, a plurality of second connecting portions (11b) formed in a second region of the first insulating substrate, the second region being different from the first region, and a plurality of coupling portions (11c) coupling the first connecting portions to the second connecting portions;
the plurality of thermoelectric conversion elements are extended in a planar direction of the first insulating substrate, while each being connected to a corresponding one of the first connecting portions and a corresponding one of the second connecting portions; and
the coupling portions each couple, in adjacent thermoelectric conversion elements, a first connecting portion connected to one of the thermoelectric conversion elements to a second connecting portion connected to the other of the thermoelectric conversion elements.

2. The thermoelectric converter according to claim 1, **characterized in that**:
the first insulating substrate is in a rectangular shape in plan view and includes the first region that is a first end region in a short side direction which is perpendicular to a longitudinal direction of the first insulating substrate and parallel to a planar direction of the first insulating substrate, and the second region that is a second end region opposite to the first end region;
the plurality of first connecting portions are formed in the first region so as to be spaced apart from each other in the longitudinal direction; and
the plurality of second connecting portions are formed in the second region so as to be spaced apart from each other in the longitudinal direction.

3. The thermoelectric converter according to claim 1, **characterized in that**:
the first insulating substrate includes a circular region centering on a predetermined reference point, the circular region including an inner-circular region as a first region, and an outer-circular region as a second region;
the plurality of first connecting portions are formed in the first region being spaced apart from each other in a circumferential direction; and
the plurality of second connecting portions are formed in the second region being spaced apart from each other in a circumferential direction.

4. The thermoelectric converter according to claim 1, **characterized in that**:
the insulating substrate is in a rectangular shape in plan view and includes, in a first end region in a longitudinal direction of the first insulating substrate, the first region that is a first lateral end region in a short side direction perpendicular to the longitudinal direction and parallel to a planar direction of the first insulating substrate, and includes, in a second end region in the longitudinal direction so as to be opposite to the first end region, the second region that is a second lateral end region in the short side direction so as to be opposite to the first lateral end region;
the plurality of first connecting portions are formed in the first region so as to be spaced apart from each other along the short side direction; and
the plurality of second connecting portions are formed in the second region so as to be spaced apart from each other along the short side direction.

5. The thermoelectric converter according to claim 1, **characterized in that**:
the insulating substrate is in a rectangular shape in plan view and includes, in a first end region in a longitudinal direction of the first insulating substrate, the first region that is a first lateral end region in a short side direction perpendicular to the longitudinal direction and parallel to a planar direction of the first insulating substrate, and includes, in a second end region in the longitudinal direction so as to be opposite to the first end region, the second region that is a second lateral end region in the short side direction so as to be opposite to the first lateral end region;
the plurality of first connecting portions are formed in the first region so as to be spaced apart from each other along the short side direction; and
the plurality of second connecting portions are formed in the second region so as to be spaced apart from each other along the longitudinal direction.

6. A method for fabricating a thermoelectric converter, the converter comprising:
a first insulating substrate (10) having a first surface (10a) on which a wiring pattern (11) is formed;
a second insulating substrate (20) arranged on the first surface of the first insulating substrate and integrated with the first insulating substrate; and
a plurality of thermoelectric conversion elements (30) of the same conductivity type arranged between the first insulating substrate and the second insulating substrate and connected in series via the wiring pattern, wherein:
the wiring pattern includes a plurality of first connecting portions (11a) formed in a first region of the first insulating substrate, a plurality of second connecting portions (11b) formed in a second region of the first insulating substrate, the second region being different from the first region, and a plurality of coupling portions (11c) coupling the first connecting portions to the second connecting portions;
the plurality of thermoelectric conversion elements are extended in a planar direction of the first insulating substrate, while each being connected to a corresponding one of the first connecting portions and a corresponding one of the second connecting portions; and
the coupling portions each couple, in adjacent thermoelectric conversion elements, a first connecting portion connected to one of the thermoelectric conversion elements to a second connecting portion connected to the other of the thermoelectric conversion elements, **characterized in that** the method comprises:
a step of forming the wiring pattern on a first surface of the first insulating substrate;
a step of coating one type of electrically conductive paste (31) onto a plurality of predetermined portions on a second surface (20a) of the second insulating substrate, the second surface being opposed to the first surface of the first insulating substrate;
a step of configuring a laminate (40) in which the first insulating substrate and the second insulating substrate are laminated such that the first surface of the first insulating material is opposed to the second surface of the second insulating substrate, and the electrically conductive paste coated onto each of the plurality of predetermined portions is brought into contact with a corresponding one of the first connecting portions and a corresponding one of the second connecting portions; and
a step of integrating the laminate, while forming the thermoelectric conversion elements by sintering the electrically conductive paste by heating the laminate and pressing the laminate in a laminated direction.

7. The method for fabricating a thermoelectric converter according to claim 6, **characterized in that**:
the electrically conductive paste is a pasted material obtained by adding an organic solvent to an alloy powder in which a plurality of metallic atoms retain a predetermined crystal structure; and
the step of integrating the laminate includes forming a sintered alloy, as the thermoelectric conversion elements, in which the plurality of metallic atoms are sintered in a state of retaining a crystal structure of the metallic atoms.
